# EUROPÄISCHE PATENTANMELDUNG

(11) **EP 0 709 899 A2**
(43) Veröffentlichungstag der Anmeldung: **01.05.1996**
(21) Anmeldenummer: 95810644.5
(22) Anmeldetag: 17.10.1995
(51) Int. Cl.: H01L 29/861

(54) **Halbleiterdiode mit Elektronen-Injektionsmittel**

(30) Priorität: 31.10.1994 DE 4438896
(71) Anmelder: ABB Management AG, CH-5401 Baden (CH)
(72) Erfinder: Bauer, Friedhelm, Dr., CH-5034 Suhr (CH)

(57) **Zusammenfassung**

Es wird eine Diode (1) angegeben, welche auf der anodenseitigen Hauptfläche (3) Elektronen-Injektionsmittel aufweist. Nach dem Durchlaufen der Rückstromspitze injizieren diese Mittel Elektronen in den Anodenemitter. Dadurch werden Löcher kompensiert und die Gefahr einer dynamischen Feldüberhöhung, welche zu einem Lawinendurchbruch führen kann, wird reduziert. Die Elektronen-Injektionsmittel umfassen vorzugsweise eine n-Kanal MOS-Zelle. Mit einer erfindungsgemässen Diode können hohe Spannungen und hohe dI/dt-Werte sicher beherrscht werden. Eine Diode nach der Erfindung wird vorzugsweise als Freilaufdiode in einer Stromrichterschaltungsanordnung verwendet.

## Beschreibung

### Technisches Gebiet

Die Erfindung bezieht sich auf das Gebiet der Halbleiterdioden. Sie betrifft insbesondere eine Freilaufdiode für Stromrichterschaltungsanordnungen.

### Stand der Technik

Im Artikel "Comparison of High Voltage Power Rectifier Structures" von M. Mehrotra und B.J. Baliga, Proceedings of the ISPSD, pp. 199-204, IEEE 1993 werden verschiedene Strukturen von Hochspannungsdioden diskutiert. Verglichen werden Dioden nach dem PiN-, P-iN, MPS, SSD, SPEED und SFD Konzept. Insbesondere wird die Rückstromproblematik beim Kommutieren eines Stromes untersucht.

Solche Dioden umfassen zwischen einer kathoden- und einer anodenseitigen Hauptfläche ein n-dotiertes Halbleitersubstrat, in welches von der anodenseitigen Hauptfläche her ein stark p-dotierter Anodenemitter und von der kathodenseitigen Hauptfläche her ein stark n-dotierter Kathodenemitter eindiffundiert ist. Anode und Kathode werden durch die entsprechende Hauptfläche bedeckende Metallschichten gebildet.

In modernen Umrichtern verursachen die Freilaufdioden häufig Fehler, insbesondere bei hohen Änderungsgeschwindigkeiten von Strom und Spannung während der Kommutierung eines Stromes. Dies führt bei den heutigen Freilaufdioden dazu, dass neben dem Halbleiterschalter auch die Freilaufdiode massiv mit passiven Schutzbeschaltungen geschützt werden muss. Die Ursache liegt in der Speicherladung der Diode, welche beim Abschalten (Kommutierung des Stroms) zu der bekannten Rückstromspitze führt. Die Stromänderung darf bei heutigen Freilaufdioden für GTOs ca. 300 A/µs nicht übersteigen.

Diese Problematik wird bei den zukünftigen, verglichen mit den GTOs schnelleren, MOS gesteuerten Halbleiterschaltern (z.B. Hochspannungs-IGBTs mit Blockierspannungen von 2.5 kV bis 4.5 kV) noch kritischer. Der IGBT ist ein vergleichsweise schneller Schalter, der selbst sehr hohe dI/dt Werte zuverlässig handhaben kann. Damit steigt aber auch die Belastung der Freilaufdioden. Darüberhinaus wäre es aus Kostengründen wünschenswert, wenn die Freilaufdiode auch ohne Schutzbeschaltung (Snubber) betrieben werden könnte. Dies hat unter anderem zu optimierten Diodenkonzepten geführt (siehe z.B. das SPEED Konzept in o.g. Artikel), welche auf den Betrieb mit schnellen IGBTs mit Blockierspannungen bis 1600 V zugeschnitten sind.

Eine Minimierung der Speicherladung z.B. durch kurze Trägerlebensdauern führt in allgemeinen zu einer Reduktion der Rückstromspitze. Mit den flachen Plasmaprofilen, welche beispielsweise durch das SPEED Konzept ermöglicht werden, kann ein schneller Spannungsanstieg und damit eine kurze Dauer des Kommutierungsvorganges erzielt werden. Aber selbst unter Ausnutzung aller Möglichkeiten zur Minimierung der Speicherladung und zur Begrenzung der Rückstromspitze steigt bei derart optimierten Dioden die Verlustleistung auf so hohe Werte an, dass ein Lawinendurchbruch der Diode wahrscheinlich wird.

### Darstellung der Erfindung

Aufgabe der vorliegenden Erfindung ist es deshalb, eine Diode anzugeben, mit welcher hohe dI/dt Werte und hohe Spannungen problemlos beherrscht werden können, insbesondere ohne dass die Gefahr eines Lawinendurchbruchs zunimmt.

Diese Aufgabe wird bei einer Diode der eingangs genannten Art durch die Merkmale des ersten Anspruchs gelöst.

Kern der Erfindung ist es also, dass auf der anodenseitigen Hauptfläche Elektronen-Injektionsmittel vorgesehen sind, welche so ausgebildet sind, dass sie eine Injektion von Elektronen bei der Kommutierung eines Stroms ermöglichen.

Das erfindungsgemässe Konzept basiert auf folgenden physikalischen Tatsachen und Überlegungen:

Untersuchungen an Dioden haben gezeigt, dass das Maximum der Verlustleistung nicht bei den höchsten Stromdichten liegt sondern eher im Bereich niedriger Werte. Da die Rückstromspitze nicht sehr stark von der Durchlassstromdichte abhängt, wird die Speicherladung bei niedrigen Durchlassstromdichten schneller abgebaut. Dies zieht einen schnelleren Spannungsanstieg nach sich. Bemerkenswert ist die Tatsache, dass die Rückstromspitze und die Verlustleistungsspitze nicht zum gleichen Zeitpunkt sondern mit einer kurzen Verzögerung stattfinden. Die Verlustleistungsspitze ereignet sich im Bereich positiver Werte von dI/dt. Nach der Umpolung der Diodenspannung fliessen die Löcher durch die Raumladungszone über die Anode ab, während die Elektronen über den n+ Emitter zu Kathode zurückkehren. Für den Durchbruch der Diode ist somit die von den Löchern verursachte dynamische Feldüberhöhung der Anode verantwortlich (Dieses Phänomen ist unter dem Begriff "dynamic avalanche" bekannt). Der dynamische Durchbruch erfolgt bei Spitzenverlustleistungen von ca. 300 bis 500 kW/cm.

Demzufolge ist eine Diodenstruktur wünschenswert, bei welcher während des Abschaltens bzw. Kommutierens des Stroms von der Anodenseite her kontrolliert weitere Elektronen injiziert werden können. Die negative Ladung der Elektronen kompensiert einen Teil der positiven Ladung der Löcher. Damit kann die dynamische Feldüberhöhung weitgehend reduziert werden, so dass für die Höhe des elektrischen Feldes im wesentlichen nur die Höhe der Dotierung massgebend ist.

Vorzugsweise erfolgt die Kontrolle dieses Elektronenspenders über eine MOS-Steuerelektrode (Gate). Eine bevorzugte Struktur, welche steuerbare Elektronen-Injektionsmittel auf der anodenseitigen Hauptfläche umfasst, weist dort nach der Erfindung mindestens ein n-Kanal MOS-Zelle auf.

Diese MOS-Zelle kann in den stark p-dotierten Anodenemitter der Diode dadurch integriert werden, dass die Anodenemitter als wannenförmige Gebiete ausgebildet sind, wobei das Halbleitersubstrat zwischen zwei benachbarten Anodenemittergebieten an die anodenseitige Hauptfläche dringt. Die MOS-Zellen werden nun durch stark n-dotierte Kurzschlussgebiete gebildet, welche an beiden Rändern der Anodenemittergebiete angeordnet sind. Darüber ist einer Steuerelektrode angeordnet, welche jeweils von einem Kurzschlussgebiet eines Anodenemittergebiets über das an die Hauptfläche dringende Halbleitersubstrat bis zum Kurzschlussgebiet des benachbarten Anodenemittergebiets reicht.

Zum Abbau der durch die Löcher verursachten Feldüberhöhung wird nun z.B. einige Bruchteile von µs nach der Rückstromspitze der n-Kanal der MOS-Zellen geöffnet. Dies kann durch Anlegen einer gegenüber der Anode positiven Spannung von ca. 15 V an die Steuerelektrode erreicht werden. Da die Kathode der Diode im Sperrfall gegenüber der Anode positiv ist, fliessen die Elektronen in Richtung der Kathode ab und somit den zur Anode fliessenden Löchern entgegen. Damit wird die geforderte Neutralisierung der positiven Löcherladung erreicht, und eine Reduktion des elektrischen Feldes kann erzielt werden.

Eine Freilaufdiode nach der Erfindung wird vorzugsweise als Freilaufdiode in Stromrichterschaltungsanordnungen mit Halbleiterschaltern eingesetzt. Eine Freilaufdiode ist antiparallel zum Halbleiterschalter angeordnet und übernimmt einen in Sperrichtung des Halbleiterschalters fliessenden Strom. Zum Betrieb und zur Ansteuerung der erfindungsgemässen Diode kann eine eigene Steuereinheit vorgesehen sein, welche die geforderte Steuerspannung von ca. 15 V generiert und zum richtigen Zeitpunkt an die Steuerelektrode anlegt. Die Steuereinheit für die Diode kann selbstverständlich auch in eine für die Halbleiterschalter sowieso schon vorhandene integriert werden.

Eine besonders kostengünstige Variante ist dadurch gekennzeichnet, dass an Stelle einer eigenen Steuereinheit für die Diode eine Induktivität in den Anodenstrompfad geschaltet wird. Diese Induktivität, welche im Idealfall bereits durch die Induktivität der Bonddrähte gegeben ist, erzeugt eine Spannung, die proportional zur Stromänderungsgeschwindigkeit dI/dt ist. Die Polarität dieser Spannung gegenüber der Anode ist derart, dass die Steuerelektrode der erfindungsgemässen Diode negativ gepolt ist im Bereich abnehmenden Diodenstroms, d.h. bis zu dem Zeitpunkt, wo die Rückstromspitze erreicht wird. Nach dem Durchlaufen der Rückstromspitze wechselt die Polarität der induzierten Spannung, so dass die Steuerelektrode mit einer positiven Spannung beaufschlagt wird. Diese positive Spannung stellt sich ungefähr zum Zeitpunkt der maximalen Verlustleistung ein. Damit führt diese Spannung zur erwünschten Injektion von Elektronen, die der Feldüberhöhung durch Löcher (dynamic avalanche) entgegenwirken.

Weitere Ausführungsbeispiele ergeben sich aus den entsprechenden abhängigen Ansprüchen.

Insgesamt ermöglicht die erfindungsgemässe Diode die Handhabung hoher dI/dt Werte und Spannungen ohne dass die Gefahr eines Lawinendurchbruchs besteht.

### Kurze Beschreibung der Zeichnungen

Nachfolgend wird die Erfindung anhand von Ausführungsbeispielen im Zusammenhang mit den Zeichnungen näher erläutert.

Es zeigen:
- **Fig. 1**: Einen Ausschnitt einer erfindungsgemässen Diode im Schnitt;
- **Fig. 2**: Eine Schaltungsanordnung, in welcher die Diode nach der Erfindung eingesetzt werden kann;
- **Fig. 3**: Eine weitere Schaltungsanordnung für welche die erfindungsgemässe Diode geeignet ist.

Die in den Zeichnungen verwendeten Bezugszeichen und deren Bedeutung sind in der Bezeichnungsliste zusammengefasst aufgelistet. Grundsätzlich sind in den Figuren gleiche Teile mit gleichen Bezugszeichen versehen.

### Wege zur Ausführung der Erfindung

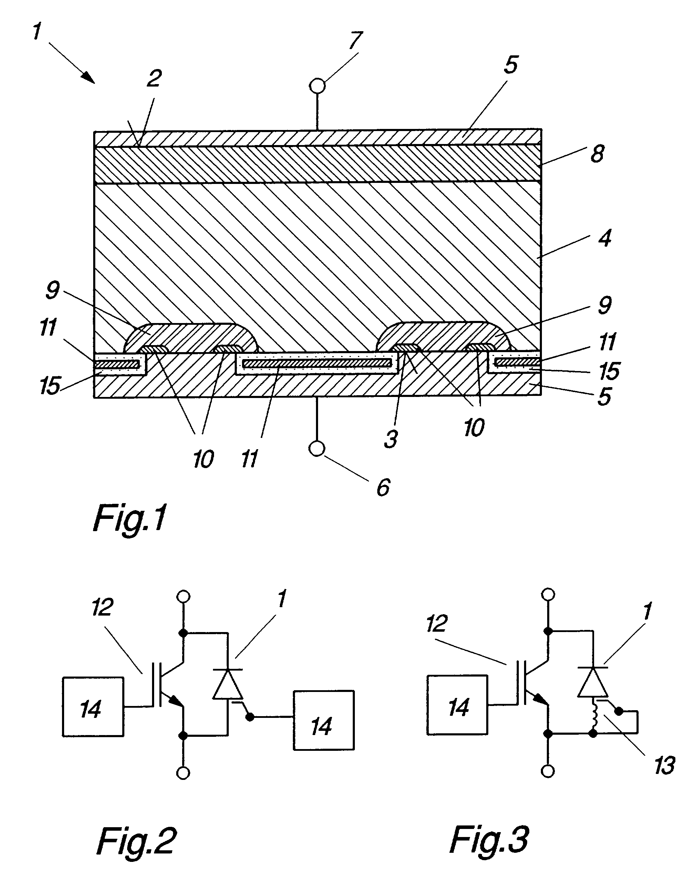

**Figur 1** zeigt einen Ausschnitt einer Diode nach der Erfindung im Schnitt. Eine solche Diode 1 umfasst zwischen einer ersten Hauptfläche 2 und einer zweiten Hauptfläche 3 ein n-dotiertes Halbleitersubstrat 4. In der Figur sind n-dotierte Gebiete von oben links nach unten rechts schraffiert, p-dotierte Gebiete sind mit Doppellinien schraffiert und Metallisierungen mit von oben rechts nach unten links verlaufenden Linien. Bei den Halbleitergebieten entspricht die Dichte der Schraffierung in etwa der Konzentration der Dotierung.

Von der ersten Hauptfläche 2 her ist in das Halbleitersubstrat 4 ein n+ dotierter Kathodenemitter 8 eindiffundiert und von der Hauptfläche 3 her ein p+ dotierter Anodenemitter 9. Die entsprechenden Elektroden, Kathode 7 und Anode 6, werden durch die zugehörigen Emitter 8 bzw. 9 bedeckende Metallschichten 5 gebildet.

Nach der Erfindung umfasst der Anodenemitter 9 mindestens ein wannenförmiges Gebiet, welches von der Metallisierung 5 der Anodenelektrode 6 kontaktiert wird. Zwischen zwei benachbarten Anodenemittergebieten 9 dringt das Halbleitersubstrat 4 an die zweite Hauptfläche 3. Für die Erfindung wesentlich sind die n+ dotierten Kurzschlussgebiete 10, welche auf beiden Seiten der wannenförmigen Anodenemittergebiete 9 angeordnet sind. Die Kurzschlussgebiete 10 und das an die zweite Hauptfläche 3 dringende Halbleitersubstrat 4 zwischen zwei benachbarten Anodenemittergebieten 9 sind von einer isoliert angeordneten Steuerelektrode 11 überdeckt. Die Isolation 15 (gepunktetes Gebiet in Figur 1) kann beispielsweise aus SiO2 bestehen, die Steuerelektrode z.B. aus Polysilizium. Derjenige Teil des Anodenemitters 9, der vom Rand bis zu den Kurzschlussgebieten 10 reicht und von der Steuerelektrode 11 überdeckt ist wird im folgenden als Kanalgebiet bezeichnet. Legt man nun an die Steuerelektrode gegenüber der Anode eine positive Spannung, so bildet sich in den Kanalgebieten ein n-Kanal aus. Dadurch werden Elektronen injiziert. Die erfindungsgemässe Struktur des Anodenemitters arbeitet also wie eine MOS-gesteuerte Elektronen-Injektionsquelle.

Der p+ dotierte Anodenemitter 9 der Diode 1 nach der Erfindung hat im Gegensatz zu dem eingangs erwähnten SPEED Konzept eine sehr hohe Injektionseffizienz. Bei einer Trägerlebensdauer von nur 4 µs für Elektronen und 1 µs für Löcher ergibt sich bei einer Stromdichte von 100 A/cm lediglich eine Durchlassspannung von 2 V.

Die erfindungsgemässe Diode 1 wird mit Vorteil in einer Stromrichterschaltungsanordung mit mindestens einem Halbleiterschalter 12 als Freilaufdiode eingesetzt. Die Figuren 2 und 3 zeigen solche Schaltungsanordnungen. Der Halbleiterschalter 12 bildet z.B. einen Teil eines mehrphasigen Umrichters. Wie abgebildet kann es sich um einen IGBT handeln, andere Typen von Halbleiterschaltern sind aber auch möglich.

Für die Ansteuerung der Diode 1 nach der Erfindung kann eine funktionell separate Ansteuereinheit 14 vorgesehen sein (Figur 2). Es ist dabei unerheblich, ob diese physisch in eine gegebenenfalls schon vorhandene Ansteuereinheit 14 eines Halbleiterschalters 12 integriert wird. Handelt es sich beim Halbleiterschalter z.B. um ein IGBT-Modul, so ist eine Integration sinnvoll, da unter Umständen bereits die Diode im IGBT-Modul integriert ist. Die Steuerungsfunktion der Diode könnte z.B. in einem erweiterten ASIC mit der Steuerfunktion des IGBT kombiniert werden.

Abgesehen davon, wo die Ansteuereinheit für die Diode vorgesehen ist, ihre Funktion muss auf jeden Fall derart sein, dass kurze Zeit nach der Rückstromspitze eine gegenüber dem Anodenpotential positive Spannung an die Steuerelektrode der Diode angelegt wird (ca. 15 V). Dadurch wird in den Kanalgebieten ein leitender n-Kanal gebildet, welche für die erwünschte Injektion von Elektronen bei der Kommutierung eines Stroms sorgt.

Die Zeit zum Anlegen der positiven Spannung richtet sich nach der Rückstromspitze. Im allgemeinen liegt bereits 50 ns bis 100 ns nach dem Durchlaufen der Rückstromspitze die volle Spannung an. Spätestens zu diesem Zeitpunkt sollte die Spannung angelegt sein.

Eine kostengünstigere und bezüglich des Schaltungsaufwands einfachere Variante besteht darin, dass an Stelle einer separaten Ansteuerungseinheit 14 für die Diode 1, lediglich ein Induktivität 13 in den Anodenpfad geschaltet wird (Figur 3). An dieser Induktivität 13 wird eine zur Stromänderung dI/dt proportionale Spannung induziert. Falls die Diode 1, in ein Modulgehäuse integriert ist, so stellen die Bonddrähte, welche die Diodenelektroden mit den Anschlüssen des Moduls verbinden, gerade die notwendige Induktivität dar. In diesem Fall kann sogar auf einer separate Induktivität verzichtet werden. Die Polarität der induzierten Spannung ist derart, dass die Steuerelektrode im Bereich mit abnehmendem Diodenstrom, d.h. bis zu dem Zeitpunkt, wo die Rückstromspitze erreicht wird, negativ gepolt wird. Sobald die Stromrichtung nach Durchlaufen der Rückstromspitze die Richtung ändert, wechselt die Polarität der induzierten Spannung und die Steuerelektrode der Diode wir mit einer positiven Spannung beaufschlagt. Dies geschieht aufgrund der üblichen endlichen Spannungsanstiegsgeschwindigkeit gerade etwa zum Zeitpunkt des Verlustleistungsmaximums. Somit wird die erwünschte Elektroneninjektion selbsttätig zum optimalen Zeitpunkt ausgelöst.

In Figur 1 ist nur ein Ausschnitt einer Diode 1 nach der Erfindung dargestellt. Für eine funktionstüchtige Diode sind jedoch mehrere der dargestellten Zellen notwendig. Da beim Kommutieren hohe Löcherstromdichten vom p+ Anodenemitter 9 kollektiert werden müssen, ist die Gefahr des Triggerns der parasitären, durch das Halbleitersubstrat 4, den Anodenemitter 9 und die Kurzschlussgebiete 10 gebildeten n-p-n Struktur wie bei einem Leistungs-MOSFET gegeben. Aus diesem Grund ist der Zellabstand, d.h. der Abstand zweier wannenförmiger Anodenemittergebiete 9, gegenüber dem IGBT deutlich kleiner zu wählen. Sehr kleine Zellabstände sind jedoch auch zu vermeiden, da infolge des JFET Effekts die Elektronenemission erschwert oder sogar völlig verhindert wird. Im Zusammenhang mit einer erprobten Diode hat sich ein Zellabstand von ca. 50 µm als optimal erwiesen.

Da die Diode nach der Erfindung insbesondere für hohe Spannungen geeignet sein soll (ab etwa 1200 V), ergibt sich für das Halbleitersubstrat 4 eine typische Dicke von >100 µm bei einer Dotierung von ca. 1-2 10¹⁴ cm⁻³. Der Kathodenemitter 8 weist dann eine typische Dotierung von >10¹⁷ cm⁻³ auf. Die isolierende Schicht 15 auf der Anodenseite weist eine Oxiddicke von ca. 100 µm. Typische Werte für die wannenförmigen Anodenemittergebiete 9 betragen: Randkonzentration ca. 10¹⁹ cm⁻³, Tiefe ca. 5 µm. Die Kurzschlussgebiete 10 werden vorzugsweise mit 10¹⁹ cm⁻³ dotiert. Die Fensteröffnung für die Metallisierung 5 im Bereich der Anodenemitter 9 beträgt typischerweise 10-20 µm.

Eine Diode nach der Erfindung weist also eine Struktur auf, mit welcher hohe Spannungen und dI/dt Werte sicher beherrscht werden können.

### Bezeichnungsliste

- 1: Halbleiterdiode
- 2: 1. Hauptfläche
- 3: 2. Hauptfläche
- 4: Halbleitersubstrat
- 5: Metallschicht
- 6: Anode
- 7: Kathode
- 8: Kathodenemitter
- 9: Anodenemitter
- 10: Kurzschlussgebiet
- 11: Steuerelektrode
- 12: Halbleiterschalter
- 13: Induktivität
- 14: Steuereinheit
- 15: Isolationsschicht

## Patentansprüche

1. Halbleiterdiode (1), insbesondere Freilaufdiode für eine Stromrichterschaltungsanordnung, umfassend zwischen einer ersten und einer zweiten Hauptfläche (2, 3) ein n-dotiertes Halbleitersubstrat (4), eine Kathode (7), welche von einer die erste Hauptfläche (2) bedeckenden Metallschicht (5) gebildet wird, und eine Anode (6), welche von einer die zweite Hauptfläche (3) bedeckenden Metallschicht (5) gebildet wird, sowie einen n-dotierten Kathodenemitter(8), welcher von der ersten Hauptfläche (2) her in das Halbleitersubstrat (4) diffundiert ist, und einen p-dotierten Anodenemitter (9), welcher von der zweiten Hauptfläche (3) her in das Halbleitersubstrat (4) diffundiert ist, dadurch gekennzeichnet, dass auf der zweiten Hauptfläche (3) Elektronen-Injektionsmittel vorgesehen sind, welche für eine Injektion von Elektronen während einer Kommutierung eines Stromes ausgeführt sind.

2. Diode nach Anspruch 1, dadurch gekennzeichnet, dass die Elektronen-Injektionsmittel mindestens eine n-Kanal MOS-Zelle umfasst.

3. Diode nach Anspruch 2, dadurch gekennzeichnet, dass der Anodenemitter (9) mehrere p-dotierte, wannenförmige Gebiete umfasst, wobei das Halbleitersubstrat (4) zwischen zwei benachbarten wannenförmigen Gebieten an die zweite Hauptfläche (3) dringt, und die MOS-Zellen n-dotierte, in die wannenförmigen Anodenemitter-Gebiete (9) eindiffundierte und von einer isoliert über der zweiten Hauptfläche (3) angeordneten Steuerelektrode (11) bedeckte Kurzschlussgebiete (10) umfassen.

4. Stromrichterschaltungsanordnung mit mindestens einem Halbleiterschalter (12), insbesondere einem IGBT, und einer Freilaufdiode, welche zum Halbleiterschalter (12) antiparallel geschaltet ist, dadurch gekennzeichnet, dass als Freilaufdiode eine Diode (1) nach einem der Ansprüche 1-3 verwendet wird.

5. Stromrichterschaltungsanordnung nach Anspruch 4 mit einer Diode nach Anspruch 3, dadurch gekennzeichnet, dass die Steuerelektrode (10) der Diode (1) mit einer Steuereinheit (14) verbunden ist, welche derart ausgeführt ist, dass sie bei der Kommutierung gegenüber der Anode (6) eine positive Spannung an die Steuerelektrode (10) anlegt.

6. Stromrichterschaltungsanordnung nach Anspruch 4 mit einer Diode nach Anspruch 3, dadurch gekennzeichnet, dass die Anode (6) über eine Induktivität (13) mit dem Halbleiterschalter (12) verbunden ist und die Steuerelektrode (10) direkt mit dem Halbleiterschalter (12) verbunden ist.

7. Stromrichterschaltungsanordnung nach Anspruch 6, dadurch gekennzeichnet, dass die Diode (1) in ein Gehäuse mit einem Anode-, Kathoden- und einem Steueranschluss integriert ist und die Induktivität (13) durch einen Anschlussdraht, der die Anode (6) mit dem Anodenanschluss verbindet, gebildet wird.
